(19) Europäisches Patentamt
European Patent Office
Office européen des brevets

(11) EP 4 202 141 A1

(12) **EUROPEAN PATENT APPLICATION**
published in accordance with Art. 153(4) EPC

(43) Date of publication:
**28.06.2023 Bulletin 2023/26**

(21) Application number: **21861386.7**

(22) Date of filing: **19.08.2021**

(51) International Patent Classification (IPC):
***E04B 1/92*** *(2006.01)* ***H01Q 17/00*** *(2006.01)*
***H05K 9/00*** *(2006.01)* ***B32B 7/025*** *(2019.01)*

(52) Cooperative Patent Classification (CPC):
**B32B 7/025; E04B 1/92; H01Q 17/00; H05K 9/00**

(86) International application number:
**PCT/JP2021/030388**

(87) International publication number:
**WO 2022/044958 (03.03.2022 Gazette 2022/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.08.2020 JP 2020140958**

(71) Applicant: **AGC INC.**
**Chiyoda-ku,**
**Tokyo 1008405 (JP)**

(72) Inventors:
- **KAWAKAMI Remi**
  **Tokyo 100-8405 (JP)**
- **NOGAMI Akiyo**
  **Tokyo 100-8405 (JP)**
- **TANAKA Tsuyoshi**
  **Tokyo 100-8405 (JP)**

(74) Representative: **Müller-Boré & Partner**
**Patentanwälte PartG mbB**
**Friedenheimer Brücke 21**
**80639 München (DE)**

(54) **RADIO WAVE ABSORBER**

(57) To provide a technique to make the thickness of a radio wave absorber thin. A radio wave absorber having a layered structure, which has a visible light transmittance of 50% or more, which absorbs radio waves in a specific frequency band, which has a first principal surface to which the radio waves enter and a second principal surface on the opposite side from the first principal surface, which has a first dielectric layer, a conductive layer, a second dielectric layer, a radio wave reflective layer and a third dielectric layer in this order from the first principal surface toward the second principal surface, and wherein the conductive layer comprises a plurality of conductors and gaps disposed to separate the plurality of conductors, and the plurality of conductors are insulated from each other.

Fig. 2

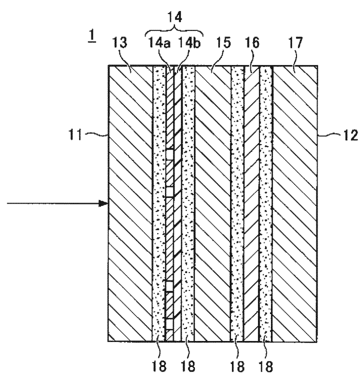


EP 4 202 141 A1

## Description

TECHNICAL FIELD

The present invention relates to a radio wave absorber.

BACKGROUND ART

The radio wave absorber disclosed in Patent Document 1 is a laminate which absorbs radio waves for wireless LAN and has a light transmittance of 50% or more. The radio wave absorber is of $\lambda/4$ type and has (A) a glass layer, (B) a PET film, (C) a resistive film, (D) a dielectric layer, (E) a reflective film, (F) a PET film and (G) a glass layer in this order from the radio wave incident direction.

PRIOR ART DOCUMENTS

PATENT DOCUMENTS

Patent Document 1: JP-A-2006-86446

DISCLOSURE OF INVENTION

TECHNICAL PROBLEM

In the $\lambda/4$ radio wave absorber, generally, the distance between the resistive film and the reflective film is about $\lambda/4$. $\lambda$ is the wavelength of radio waves. The resistive film reflects a part of radio waves, absorbs another part and transmits the other part. The radio waves reflected on the resistive film and the radio waves reflected on the reflective film interfere with each other and are cancelled out each other. As a result, the radio waves are absorbed.

In the $\lambda/4$ radio wave absorber, as described above, the distance between the resistive film and the reflective film is about $\lambda/4$. Accordingly, the longer the wavelength $\lambda$ of radio waves is, that is the lower the frequency of the radio waves is, the thicker the $\lambda/4$ radio wave absorber will be.

According to an embodiment of the present disclosure, a technique to make the radio wave absorber thin is provided.

SOLUTION TO PROBLEM

The radio wave absorber according to an embodiment of the present invention is a radio wave absorber having a laminate structure,

which has a visible light transmittance of 50% or more,
which absorbs radio waves in a specific frequency band,
which has a first principal surface to which the radio waves enter and a second principal surface on the opposite side from the first principal surface,
which has a first dielectric layer, a conductive layer, a second dielectric layer, a radio wave reflective layer and a third dielectric layer in this order from the first principal surface toward the second principal surface, and
wherein the conductive layer comprises a plurality of conductors and gaps disposed to separate the plurality of conductors, and the plurality of conductors are insulated from each other.

ADVANTAGEOUS EFFECTS OF INVENTION

According to an embodiment of the present disclosure, it is possible to make a radio wave absorber thin.

BRIEF DESCRIPTION OF DRAWINGS

Fig. 1 is a diagram illustrating the application of a radio wave absorber according to an embodiment.
Fig. 2 is a cross sectional view illustrating a first example of a radio wave absorber.
Fig. 3 is a cross sectional view illustrating a second example of a radio wave absorber.

Fig. 4 is a cross sectional view illustrating a third example of a radio wave absorber.
Fig. 5 is a plan view illustrating an example of a slit pattern of a conductive layer.
Fig. 6 is a plan view illustrating an example of the line width of a first slit and the line width of a second slit.
Fig. 7 is a diagram illustrating an example of the relation between the thickness of a second dielectric and the sheet resistance of a conductor of a conductive layer.
Fig. 8 is a cross sectional view illustrating an example of a method for measuring the attenuation of a radio wave absorber.
Fig. 9 is a graph illustrating the attenuation of the radio wave absorber prepared in Ex. 1.
Fig. 10 is a graph illustrating the ratio of the attenuation of the radio wave absorber prepared in Ex. 1 to the attenuation of a SUS plate.
Fig. 11 is a graph illustrating the attenuation of the radio wave absorber prepared in Ex. 2.
Fig. 12 is a graph illustrating the ratio of the attenuation of the radio wave absorber prepared in Ex. 2 to the attenuation of a SUS plate.

DESCRIPTION OF EMBODIMENTS

In the following, embodiments of the present disclosure will be described with reference to drawings. In the drawings, the same or corresponding structures are represented by the same reference symbols, and explanation may sometimes be omitted. In this specification, " to " used to show the range of the numerical values is used to include the numerical values before and after it as the lower limit value and the upper limit value.

First, an example of the application of a radio wave absorber 1 will be described with reference to Fig. 1. The radio wave absorber 1 absorbs unnecessary radio waves when radio waves are transmitted/received for example between RF (Radio Frequency) tags 3A, 3B and 3C attached to articles 2A, 2B and 2C, and a reader 4. It can suppress reflection of unnecessary radio waves and prevent e.g. miscounting of the number of the articles 2A, 2B and 2C.

The RF tags 3A, 3B and 3C contain a storage medium which stores information to identify the articles 2A, 2B and 2C. The RF tags 3A, 3B and 3C may, for example, be of passive type such that using radio waves emitted from the reader 4 as a power source, they transmit radio waves of information preliminarily stored in the storage medium to the reader 4. The frequency of the radio waves emitted from the RF tags 3A, 3B and 3C is for example 913 MHz.

The RF tags 3A, 3B and 3C are of passive type in the present embodiment, but may be of active type such that they contain a built-in battery as a power source.

The reader 4 receives radio waves emitted from the RF tags 3A, 3B and 3C, reads information contained in the radio waves and identifies the articles 2A, 2B and 2C. The maximum communication distance of the reader 4 is not particularly limited and is for example about 6 m. The sum of the articles 2A, 2B and 2C identified by the reader 4 is displayed on a display device.

The radio wave absorber 1 may, for example, be in a box shape and contains the reader 4 in its interior. A purchaser puts the articles 2A, 2B and 2C for example from outside the radio wave absorber 1 into inside. In such a case, to secure sense of safety for the purchaser, the radio wave absorber 1 may be required to be transparent.

The radio wave absorber 1 may have a size to such an extent that even a purchaser can enter. The purchaser enters into the interior of the radio wave absorber 1 together with the articles 2A, 2B and 2C. In such a case, the radio wave absorber 1 may be required to be transparent so that the purchaser does not feel being trapped.

That is, regardless of the position of the purchaser, the radio wave absorber 1 may sometimes be required to be transparent so that the purchaser can see the article or scenery through the radio wave absorber 1. When the radio wave absorber 1 is transparent, the interior and the exterior of the radio wave absorber can be visually recognized, and articles in the radio wave absorber 1 can automatically be visually recognized, and thus it can be used for a self checkout or a storehouse.

Now, a first example of the radio wave absorber 1 will be described with reference to Fig. 2. In Fig. 2, the direction of incidence of radio waves RF is indicted by an arrow.

The radio wave absorber 1 has a laminate structure, absorbs radio waves at a specific frequency and has a visible light transmittance of 50% or more. When the visible light transmittance is 50% or more, the purchaser can visually recognized articles or scenery through the radio wave absorber 1. The visible light transmittance is preferably 53% or more, more preferably 55% or more. Further, the visible light transmittance is preferably 90% or less, more preferably 80% or less. The visible light transmittance is obtained by measurement in accordance with Japanese Industrial Standards JIS R3106:1998 and by calculation by a calculation formula in the case of using standard illuminant D65.

The radio wave absorber 1 has a first principal surface 11 which the radio waves enter, and a second principal surface 12 on the opposite side from the first principal surface 11. The radio wave absorber 1 has, in the following order from the first principal surface 11 toward the second principal surface 12, a first dielectric layer 13, a conductive layer 14, a second dielectric layer 15, a radio wave reflective layer 16 and a third dielectric layer 17.

Further, the radio wave absorber 1 may further has an adhesive layer 18 between the first principal surface 11 and the second principal surface 12. The adhesive layer 18 is disposed at least one of between the first dielectric layer 13 and the conductive layer 14, between the conductive layer 14 and the second dielectric layer 15, between the second dielectric layer 15 and the radio wave reflective layer 16, and between the radio wave reflective layer 16 and the third dielectric layer 17. The disposition of the adhesive layer 18 is not particularly limited, the details of which will be described later.

The first dielectric layer 13 protects the conductive layer 14. The first dielectric layer 13 is made of glass, a ceramic, a resin or the like. From the viewpoint of weight saving, a resin is preferred. As specific examples of the resin, a polyethylene terephthalate (PET) resin, a polycarbonate (PC) resin and an acrylic resin may be mentioned. On the other hand, from the viewpoint of scratch resistance, glass or a ceramic is preferred.

In a case where the first dielectric layer 13 is a glass substrate or a ceramic substrate, its thickness is for example from 0.2 mm to 4.0 mm, preferably from 0.3 mm to 2.5 mm, more preferably from 0.3 mm to 1.0 mm. On the other hand, in a case where the first dielectric layer 13 is a resin substrate, its thickness is for example from 0.4 mm to 5.0 mm, preferably from 0.5 mm to 3.5 mm, more preferably from 0.5 mm to 1.5 mm.

In a case where the first dielectric layer 13 is a glass substrate, $\tan\delta$ (also called dielectric loss tangent) of the glass substrate is preferably 0.025 or less, more preferably 0.020 or less, further preferably 0.010 or less. The lower limit of $\tan\delta$ of the glass substrate is not particularly limited and may be 0.0001 or more. Further, the relative dielectric constant of the glass substrate is preferably 8 or less, more preferably 6 or less. The lower limit of the relative dielectric constant of the glass substrate is not particularly limited and may be 3.5 or more.

In a case where the first dielectric layer 13 is a resin substrate, $\tan\delta$ of the resin substrate is preferably 0.2 or less, more preferably 0.1 or less. The lower limit of $\tan\delta$ of the resin substrate is not particularly limited and may be 0.0005 or more. Further, the relative dielectric constant of the resin substrate is preferably 5 or less, more preferably 4 or less. The lower limit of the relative dielectric constant of the resin substrate is not particularly limited and may be 2 or more.

$\tan\delta$ is a value represented by $\varepsilon 2/\varepsilon 1$ employing the complex dielectric constant, and $\varepsilon 1$ is the relative dielectric constant, and $\varepsilon 2$ is the dissipation loss. The smaller $\tan\delta$ is, the smaller the absorption of radio waves in the frequency band is. $\tan\delta$ and the relative dielectric constant are values measured in accordance with the method specified in IEC (International Electrotechnical Commission) 61189-2-721 (2015), at a measurement frequency of 1 GHz.

The ratio (Ta/Tc) of the thickness (Ta) of the first dielectric layer 13 to the thickness (Tc) of the second dielectric layer 15 is for example from 0.05 to 0.75. The first dielectric layer 13 is intended to protect the conductive layer 14 and thereby may be thinner than the second dielectric layer 15.

The conductive layer 14 contains a plurality of conductors 14a disposed to be separated by gaps, insulated from each other. The conductors 14a may, for example, be a transparent conductive film such as an ITO (indium tin oxide) film or a Low-E (low emissivity) film. The conductive layer 14 may be a so-called FSS (Frequency Selective Shield).

The conductive layer 14 reflects a part of radio waves, absorbs another part, and transmit the other part. Radio waves which had transmitted through the conductive layer 14 are reflected on the radio wave reflective layer 16. The radio waves reflected on the conductive layer 14 and the radio waves reflected on the radio wave reflective layer 16 interfere with each other and are cancelled out each other. As a result, the radio waves are absorbed.

When the radio waves arrive at the conductive layer 14, free electrons in the conductors 14a move in the direction opposite to the direction of electric field of the radio waves, and an electric current flows in the conductors 14a. Further, on that occasion, at the gaps between the conductors 14a, energy is periodically accumulated and discharged by the electric field generated. As a result, propagation delay of radio waves transmitting through the conductive layer 14 occurs. That is, there is a delay time from when the radio waves enter the conductive layer 14 until when they are reradiated. Thus, the distance between the conductive layer 14 (resistive film) and the radio wave reflective layer 16 (reflective film) can be made shorter than $\lambda/4$ and the radio wave absorber 1 can be made thin. The distance between the conductive layer 14 and the radio wave reflective layer 16 is preferably from 1.5 mm to 20 mm, more preferably from 2 mm to 10mm, further preferably from 2 mm to 5 mm.

The thickness of the conductive layer 14 is not particularly limited and for example in a case where the conductive layer 14 is a Low-E (low emissivity) film, it is from 50 nm to 300 nm.

The conductive layer 14 may further has an insulating substrate 14b which supports the plurality of conductors 14a. The insulating substrate 14b may, for example, be a resin film. The plurality of conductors 14a are formed on the surface of the insulating substrate 14b. For example, a transparent conductive film is formed on the surface of the insulating substrate 14b e.g. by deposition or sputtering, and the formed transparent conductive film is patterned e.g. by laser processing. The plurality of conductors 14a may also be formed by printing using a conductive ink.

The thickness of the insulating substrate 14b is not particularly limited and may, for example, be from 50 $\mu$m to 200 $\mu$m.

In a case where the conductive layer 14 has the insulating substrate 14b, the adhesive layer 18 is disposed both between the conductive layer 14 and the first dielectric layer 13 and between the conductive layer 14 and the second dielectric layer 15. On the other hand, in a case where the conductive layer 14 contains no insulating substrate 14b, the adhesive layer 18 is disposed only one of between the conductive layer 14 and the first dielectric layer 13 and between the conductive layer 14 and the second dielectric layer 15.

In the latter case, the conductive layer 14 is adjacent to and is directly formed on one of the first dielectric layer 13 and the second dielectric layer 15. For example, as shown in Fig. 3, the conductive layer 14 is adjacent to the second dielectric layer 15 and is directly formed on the second dielectric layer 15. Otherwise, as shown in Fig. 4, the conductive layer 14 is adjacent to the first dielectric layer 13 and is directly formed on the first dielectric layer 13. Since no insulating substrate 14b is necessary, the radio wave absorber 1 can be made thinner.

Now, an example of a slit pattern of the conductive layer 14 will be described with reference to Fig. 5. The conductive layer 14 comprises a plurality of conductors 14a and gaps disposed to separate the plurality of conductors 14a, and the plurality of conductors 14a are insulated each other by the gaps. The gaps comprise a plurality of first slits 14c and a plurality of second slits 14d orthogonal to each other. The plurality of first slits 14c and the plurality of second slits 14d form quadrangular lattices, and the conductors 14a are formed rectangular as viewed two-dimensionally. The rectangular includes square.

The distances between adjacent first slits 14c are set alternately to first distances L1 and second distances L2 narrower than the first distances L1. Likewise, the distances between adjacent second slits 14d are also set alternately to first distances L1 and second distances L2. As a result, four types of conductors 14a-1, 14a-2, 14a-3 and 14a-4 are formed as viewed two-dimensionally.

The conductor 14a-1 is a square with lengths of the four sides being L1. The conductor 14a-2 is a square with lengths of the four sides being L2. The other two conductors 14a-3 and 14a-4 have lengths of facing two sides being L1 and lengths of the other two sides being L2.

The average of the lengths of the outer peripheries of the four types of conductors 14a-1, 14a-2, 14a-3 and 14a-4 is represented by the formula $2\times(L1+L2)$. The average of the lengths of the outer peripheries is for example from 60 mm to 180 mm, preferably from 80 mm to 150 mm.

L1 and L2 are different in the present embodiment but may be the same. In such a case also, the average of the lengths of the outer peripheries is represented by the formula $2\times(L1+L2)$.

Now, the relation between the line width G1 of the first slit 14c and the line width G2 of the second slit 14d will be described with reference to Fig. 6.

The first slit 14c and the second slit 14d are formed for example by laser processing as described above. The laser beam forms a spot SP on the surface of the conductive layer 14. By moving the spot SP in a first direction (X axis direction), the first slit 14c is formed. The longitudinal direction of the first slit 14c is the X axis direction. Further, by moving the spot SP in a second direction (Y axis direction) orthogonal to the first direction, the second slit 14d is formed. The longitudinal direction of the second slit 14d is the Y axis direction.

As shown in Fig. 6, the line width G1 of the first slit 14c agrees with the size of the spot SP in the Y axis direction, and the line width G2 of the second slit 14d agrees with the size of the spot SP in the X axis direction. In a case where the spot SP is elliptic, G1 and G2 are different from each other. In a case where the spot SP is circular, G1 and G2 agree with each other. In a case where G1 and G2 agree with each other, it is not necessary to distinguish G1 and G2, and they will be represented simply as G (see Fig. 5).

In Table 1, a difference in appearance of the radio wave absorber 1 between Ex. A in which the line widths G1 and G2 are 100 μm, and Ex. B in which they are 4000 μm is shown. The appearance is rated as ○ and passed in a case where the first slits 14c and the second slits 14d of the conductive layer 14 were not distinguished from the conductors 14a, when the radio wave absorber 1 was visually observed from the first principal surface 11 side, and when the radio wave absorber 1 was visually observed from the second principal surface side. On the other hand, it is rated as × and failed in a case where the first slits 14c and the second slits 14d of the conductive layer 14 were distinguished from the conductors 14a, at least on of when the radio wave absorber 1 was visually observed from the first principal surface 11 side, and when the radio wave absorber 1 was visually observed from the second principal surface 12 side.

[Table 1]

| | Conductive layer | | Appearance |
|---|---|---|---|
| | G1 [μm] | G2 [μm] | |
| Ex. A | 100 | 100 | ○ |
| Ex. B | 4000 | 4000 | × |

In Ex. A in Table 1, the radio wave absorber 1 was a 5-layered laminate having the first dielectric layer 13, the conductive layer 14, the second dielectric layer 15, the radio wave reflective layer 16 and the third dielectric layer 17 in this order. The laminate was disposed so that the first principal surface 11 stood vertically, the longitudinal direction of the first slits 14c was horizontal, and the longitudinal direction of the second slits 14d was vertical. The first dielectric layer 13 and the third dielectric layer 17 were both PC resin substrates (relative dielectric constant: 2.96, tanδ: 0.011) having a thickness of 2.0 mm. The second dielectric layer 15 was a glass substrate (relative dielectric constant: 7.0, tanδ: 0.02) having a thickness of 4.0 mm. Of the conductive layer 14, L1 was 35 mm, L2 was 21 mm, G1 was 100 μm, G2 was 100 μm, and the sheet resistance was 1.8 Ω/sq. The radio wave reflective layer 16 was a perfect magnetic conductor (PEC).

In Ex. B in Table 1, the radio wave absorber 1 (manufactured by Microwave Absorbers Inc., product number "MS-009T") was a 5-layered laminate having the conductive layer 14 comprising the insulating substrate 14b and the conductors 14a, the second dielectric layer 15, and the radio wave reflective layer 16 comprising a tile-shaped layer and a solid film-formed layer in this order. The laminate was disposed so that the first principal surface 11 stood vertically, the longitudinal direction of the first slits 14c was horizontal, and the longitudinal direction of the second slits 14d was vertical. The second dielectric layer 15 was an acrylic resin (relative dielectric constant: 2.7, tanδ: 0.04) having a thickness of 5.0 mm. Of the conductive layer 14, L1 was 86 mm, L2 was 86 mm, G1 was 4000 μm, G2 was 4000 μm, and the sheet resistance was 5.38 Ω/sq. Of the radio wave reflective layer 16, the tile-shaped layer had a sheet resistance of 3.21 Ω/sq., the solid film-formed layer had a sheet resistance of 2.64 Ω/sq., and the whole radio wave reflective layer 16 had a sheet resistance of 1.57 Ω/sq.

G1 and G2 are each independently preferably from 30 μm to 500 μm, more preferably from 50 μm to 200 μm, further preferably from 50 μm to 150 μm. When G1 and G2 are 30 μm or more, processing will be easy. As evident from Table 1, when G1 and G2 are 500 μm or less, the distance between adjacent conductive layers 14 (14a-1, 14a-2, 14a-3, 14a-4) is suppressed, the slits are less likely to be visually recognized, and a radio wave absorber 1 with favorable transparency is thereby obtained. When G1 and G2 are 150 μm or less, the electric field generated between the conductors 14a tends to be large, and the delay time tends to be long. Accordingly, the distance between the conductive layer 14 and the radio wave reflective layer 16 can be shortened, and the radio wave absorber 1 can be made thin.

In Table 2, shifts of the frequency at which the attenuation of radio waves becomes minimum when G1 is fixed at 100 μm and G2 is changed, are shown. The attenuation (unit: dB) represents the intensity of reflected radio waves to the intensity of incident radio waves by a negative value. The smaller the attenuation, the lower the intensity of reflected radio waves to the intensity of incident radio waves, and the larger the absorption of radio waves. For example, an attenuation being -10 dB means that the intensity of reflected radio waves is 1/10 of the intensity of incident radio waves. An attenuation being -20 dB means that the intensity of reflected radio waves is 1/100 of the intensity of incident radio waves. The attenuation of radio waves was obtained by electric field simulation. As an analysis software, CST Microwave Studio (registered trademark) was used. The attenuations in Tables 3 to 8 were obtained in the same manner.

[Table 2]

| Conductive layer | | | Frequency at which attenuation becomes minimum [MHz] | Shift of frequency [%] |
|---|---|---|---|---|
| G1 [μm] | G2 [μm] | \|G1-G2\|/G1 [%] | | |
| 100 | 90 | 10 | 870 | 4.4 |
| 100 | 100 | 0 | 910 | 0.0 |
| 100 | 110 | 10 | 930 | 2.2 |
| 100 | 120 | 20 | 940 | 3.4 |

In Table 2, the radio wave absorber 1 was a 5-layered laminate having the first dielectric layer 13, the conductive layer 14, the second dielectric layer 15, the radio wave reflective layer 16 and the third dielectric layer 17 in this order. The laminate was disposed so that the first principal surface 11 stood vertically, the longitudinal direction of the first slits 14c was horizontal, and the longitudinal direction of the second slits 14d was vertical. The first dielectric layer 13 and the third dielectric layer 17 were both PC resin substrates (relative dielectric constant: 2.96, tanδ: 0.011) having a thickness of 2.0 mm. The second dielectric layer 15 was a glass substrate (relative dielectric constant: 7.0, tanδ: 0.02) having a thickness of 4.0 mm. Of the conductive layer 14, L1 was 35 mm, L2 was 21 mm, and the sheet resistance was 1.8 Ω/sq. The radio wave reflective layer 16 was a perfect magnetic conductor (PEC).

As evident from Table 2, when |G1-G2|/G1 is 30% or less, the shift of the frequency at which the attenuation becomes minimum can be suppressed to be 5% or less. The shift of the frequency represents the degree of deviation from the reference value by percentage, the reference value being the frequency (910 MHz in Table 2) at which the attenuation becomes minimum when G1 and G2 are equal to each other. |G1-G2|/G1 is a ratio of the absolute value |G1-G2| of the difference between the average value G1 of the line widths of the first slits 14c and the average value G2 of the line widths of the second slits 14d, to the average value G1 of the line widths of the first slits 14c. |G1-G2|/G1 is preferably 20% or less. Further, |G1-G2|/G1 is 0% or more.

The second dielectric layer 15 prolongs the delay time, further decreases the distance between the conductive layer 14 and the radio wave reflective layer 16, and make the radio wave absorber 1 thinner. The thickness of the second dielectric layer 15 is for example from 1.5 mm to 20 mm. When the thickness of the second dielectric layer 15 is within the above range, the distance between the conductive layer 14 and the radio wave reflective layer 16 will be appropriate.

The second dielectric layers 15 made of different materials have different dielectric constants, and preferred ranges of the thickness are also different. In a case where the second dielectric layer 15 is a resin substrate, the thickness of the second dielectric layer 15 is for example from 2.0 mm to 25 mm, preferably from 3.0 mm to 20 mm, more preferably from 3.0 mm to 7.0 mm. In a case where the second dielectric layer 15 is a glass substrate or a ceramic substrate, the thickness of the second dielectric layer 15 is for example from 1.0 mm to 15 mm, preferably from 1.5 mm to 10.0 mm, more preferably from 1.5 mm to 5.0 mm.

The material of the second dielectric layer 15 is glass, a ceramic or a resin. From the viewpoint of weight saving, a resin is preferred. As specific examples of the resin, a PC resin and an acrylic resin may be mentioned. Whereas from the viewpoint of the coefficient of water absorption, glass or a ceramic is preferred. Further, from the viewpoint of the tolerance of the thickness of the second dielectric layer 15, the details of which will be described later, a resin is preferred. The tolerance is an acceptable difference. The larger the tolerance, the better.

In a case where the second dielectric layer 15 is a glass substrate, tanδ of the glass substrate is preferably 0.025 or less, more preferably 0.020 or less, further preferably 0.010 or less. The lower limit of tanδ of the glass substrate is not particularly limited and may be 0.0001 or more. Further, the relative dielectric constant of the glass substate is preferably 8 or less, more preferably 6 or less. The lower limit of the relative dielectric constant of the glass substrate is not particularly limited and may be 3.5 or more.

In a case where the second dielectric layer 15 is a resin substate, tanδ of the resin substrate is preferably 0.2 or less, more preferably 0.1 or less. The lower limit of tanδ of the resin substrate is not particularly limited and may be 0.0005 or more. Further, the relative dielectric constant of the resin substrate is preferably 5 or less, more preferably 4 or less. The lower limit of the relative dielectric constant of the resin substrate is not particularly limited and may be 2 or more.

In Table 3, variations of the attenuation of radio waves when the thickness of the PC resin substrate as the second dielectric layer 15 is changed are shown. The attenuations of radio waves were obtained under the same conditions except for the thickness of the PC resin substrate as the second dielectric layer 15.

[Table 3]

| Second dielectric layer | | Attenuation at frequency of 915 MHz [dB] | Attenuation at frequency of 902 MHz [dB] | Attenuation at frequency of 928 MHz [dB] |
|---|---|---|---|---|
| Material | Thickness [mm] | | | |
| PC | 7.60 | -13.02 | -10.46 | -16.34 |
| PC | 7.80 | -16.35 | -12.84 | -20.52 |
| PC | 8.00 | -21.46 | -16.59 | -21.63 |
| PC | 8.20 | -24.15 | -21.17 | -18.63 |
| PC | 8.40 | -18.37 | -24.85 | -14.29 |

In Table 3, the radio wave absorber 1 was a 5-layered laminate having the first dielectric layer 13, the conductive layer 14, the second dielectric layer 15, the radio wave reflective layer 16 and the third dielectric layer 17 in this order. The laminate was disposed so that the first principal surface 11 stood vertically, the longitudinal direction of the first slits 14c was horizontal, and the longitudinal direction of the second slits 14d was vertical. The first dielectric layer 13 and the third dielectric layer 17 were both PC resin substrates having a thickness of 2.0 mm. Of the conductive layer 14, G was 100 μm, L1 was 34 mm, L2 was 26 mm, and the sheet resistance was 10 Ω/sq. The radio wave reflective layer 16 was a perfect magnetic conductor.

In Table 3, a case where the attenuation of radio waves at a frequency of 915 MHz was -20 dB or less, and the attenuations of radio waves at frequencies of 902 MHz and 928 MHz around the frequency of 915 MHz were -10 dB or less, was rated passed. The other cases were rated failed. As evident from Table 3, in a case where the second dielectric layer 15 is a PC resin substrate, the tolerance of the thickness of the second dielectric layer 15 for passing is about 0.4 mm.

In Table 4, variations of the attenuation of radio waves when the thickness of the glass substrate as the second dielectric layer 15 is changed. The attenuations of radio waves were obtained under the same conditions except for the thickness of the glass substrate as the second dielectric layer 15.

[Table 4]

| Second dielectric layer | | Attenuation at frequency of 915 MHz [dB] | Attenuation at frequency of 902 MHz [dB] | Attenuation at frequency of 928 MHz [dB] |
|---|---|---|---|---|
| Material | Thickness [mm] | | | |
| Glass | 3.65 | -14.86 | -9.46 | -20.92 |
| Glass | 3.70 | -21.26 | -13.90 | -14.23 |
| Glass | 3.75 | -18.26 | -18.20 | -11.40 |
| Glass | 3.80 | -13.96 | -22.30 | -9.16 |
| Glass | 3.85 | -14.04 | -23.70 | -9.17 |
| Glass | 3.90 | -11.62 | -19.60 | -7.88 |

In Table 4, the radio wave absorber 1 was a 5-layered laminate having the first dielectric layer 13, the conductive layer 14, the second dielectric layer 15, the radio wave reflective layer 16 and the third dielectric layer 17 in this order. The laminate was disposed so that the first principal surface 11 stood vertically, the longitudinal direction of the first slits 14c was horizontal, and the longitudinal direction of the second slits 14d was vertical. The first dielectric layer 13 and the third dielectric layer 17 were both glass substrates having a thickness of 2.7 mm. Of the conductive layer 14, G was 120 μm, L1 was 30 mm, L2 was 20 mm, and the sheet resistance was 1.8 Ω/sq. The radio wave reflective layer 16 was a perfect magnetic conductor.

In Table 4, in the same manner as in Table 3, a case where the attenuation of radio waves at a frequency of 915 MHz was -20 dB or less, and the attenuations of radio waves at frequencies of 902 MHz and 928 MHz around the frequency of 915 MHz were -10 dB or less, was rated passed. The other cases were rated failed. As evident from Table 3, in a case where the second dielectric layer 15 is a glass substrate, the tolerance of the thickness of the second dielectric layer 15 for passing is about 0.05 mm.

As evident from Tables 3 and 4, as the material of the second dielectric layer 15, from the viewpoint of the tolerance of the thickness of the second dielectric layer 15, a resin is preferred to glass. When the second dielectric layer 15 is made of a resin, the tolerance of the thickness of the second dielectric layer 15 is large, and even when the thickness of the second dielectric layer 15 is dispersed among the production lots of the second dielectric layer 15, radio waves will sufficiently be attenuated.

Now, an example of the relation of the thickness of the second dielectric layer 15 and the sheet resistance of the conductors 14a of the conductive layer 14 will be described with reference to Fig. 7. In Fig. 7, the second dielectric layer 15 is made of a PC resin (relative dielectric constant: 2.96, tanδ: 0.011). Where the thickness of the second dielectric layer 15 is x (mm), and the sheet resistance of the conductors 14a of the conductive layer 14 is y (Ω/sq.), the following formula (1) is preferably satisfied.

$$0.23x^2 - 1.50x + 2.41 \leqq y \leqq 0.11x^2 + 1.09x - 1.36 \qquad (1)$$

The range in which the above formula (1) is satisfied is the range illustrated by the dotted pattern in Fig. 7. When the formula (1) is satisfied, the attenuation of radio waves is -10db or less, and radio waves will sufficiently be attenuated. As evident from Fig. 7, it is preferred that the larger x is, the higher y is. It is more preferred that the following formula (2) is satisfied.

$$y = 0.15x^2 + 0.12x - 0.86 \qquad (2)$$

The radio wave reflective layer 16 reflects radio waves that have been transmitted through the conductive layer 14. The radio wave reflective layer 16 has conductivity. The sheet resistance of the radio wave reflective layer 16 is for example lower than 3 Ω/sq., preferably 2 Ω/sq. or less, more preferably 1.5 Ω/sq. or less. Further, the sheet resistance of the radio wave reflective layer 16 is preferably 0.1 Ω/sq. or more, more preferably 0.5 Ω/sq. or more.

In Table 5, variations of the band width at which the attenuation becomes -10 db or less, when the sheet resistance of the radio wave reflective layer 16 is changed, are shown. The attenuations of radio waves were obtained under the same conditions except for the sheet resistance of the radio wave reflective layer 16.

[Table 5]

| Sheet resistance of reflective layer [Ω/sq.] | Frequency at which attenuation becomes minimum [MHz] | Band width at which attenuation becomes -10 dB or less [MHz] |
|---|---|---|
| 0.01 | 1050 | 50 |
| 0.1 | 1050 | 50 |
| 1 | 1050 | 70 |
| 5 | 1080 | 0 |
| 10 | 1080 | 0 |

In Table 5, the radio wave absorber 1 was a 8-layered laminate having the first dielectric layer 13, the adhesive layer 18, the conductive layer 14, the second dielectric layer 15, the adhesive layer 18, the radio wave reflective layer 16, the adhesive layer 18 and the third dielectric layer 17 in this order. The laminate was disposed so that the first principal surface 11 stood vertically, the longitudinal direction of the first slits 14c was horizontal, and the longitudinal direction of the second slits 14d was vertical. The first dielectric layer 13 and the third dielectric layer 17 were both glass substrates having a thickness of 2.75 mm. The second dielectric layer 15 was a glass substrate having a thickness of 3.7 mm. Of the conductive layer 14, G was 120 $\mu$m, L1 was 30 mm, L2 was 20 mm, and the sheet resistance was 1.8 Ω/sq. Each adhesive layer 18 was a COP film (relative dielectric constant: 2.33, tan$\delta$: 0.00086) having a thickness of 0.5 mm.

As evident from Table 5, in order to secure a band with at which the attenuation becomes -10 db or less of 26 MHz or more, the sheet resistance of the radio wave reflective layer 16 should be lower than 3 Ω/sq. The sheet resistance of the radio wave reflective layer 16 is most preferably about 1 Ω/sq.

The radio wave reflective layer 16 contains for example a metal mesh. The metal mesh, which has openings, can realize a higher visible light transmittance as compared with a metal film. With a view to suppressing reflection of visible light, the metal mesh is preferably one subjected to oxidation treatment for blackening. The metal mesh is commonly made of stainless steel. When the mesh wire size is 0.01mm or more, handling efficiency when the radio wave absorber 1 is produced will be good. When the mesh wire size is 0.1mm or less, radio wave absorption property will be favorable. The mesh wire size is, with a view to securing transparency of the radio wave absorber and satisfying radio wave absorption property at the same time, particularly preferably from 0.01 mm to 0.08 mm, more preferably from 0.02 mm to 0.06 mm.

Further, the radio wave reflective layer 16 may contain a transparent conductive film. The transparent conductive film may, for example, be an ITO film or a Low-E film (low emissivity film). The thickness of the radio wave reflective layer is not particularly limited, and in a case where a metal film such as a Low-E film is used for the radio wave reflective layer 16, it is for example from 100 nm to 500 nm.

The radio wave reflective layer 16 may further have an insulating substrate which supports the transparent conductive film. The insulating substrate is for example a resin film. For example, the transparent conductive film is formed on the surface of the insulating substrate e.g. by deposition or sputtering. The transparent conductive film may be formed by printing using a conductive ink.

In a case where the radio wave reflective layer 16 has the insulating substrate, as shown in Figs. 2 and 3, the adhesive layer 18 is disposed both between the radio wave reflective layer 16 and the third dielectric layer 17 and between the radio wave reflective layer 16 and the second dielectric layer 15. On the other hand, in a case where the radio wave reflective layer 16 has no insulating substrate, the adhesive layer 18 is disposed only one of between the radio wave reflective layer 16 and the third dielectric layer 17 and between the radio wave reflective layer 16 and the second dielectric layer 15.

In the latter case, the radio wave reflective layer 16 is adjacent to and directly formed on one of the third dielectric layer 17 and the second dielectric layer 15. For example, as shown in Fig. 4, the radio wave reflective layer 16 is adjacent to the third dielectric layer 17 and is directly formed on the third dielectric layer 17. Otherwise, the radio wave reflective layer 16 is adjacent to the second dielectric layer 15 and is directly formed on the second dielectric layer 15, although not shown. Since no insulating substrate is necessary, the radio wave absorber 1 can be made thinner.

By the way, as the Low-E film, one containing a tin oxide layer or an indium oxide layer, and one containing a silver (Ag) layer are present.

The Low-E film containing a tin oxide layer or an indium oxide layer is advantageous in that it is less deteriorated by heat, however, it originally has high emissivity (vertical emissivity εn of about 0.15 or more), and improvement in heat insulating property and heat shielding property can hardly be expected, and heat shielding property at the time of fire cannot be expected. That is, remarkable improvement in fire proof performance cannot be expected.

On the other hand, the Low-E film containing a silver layer has a low emissivity (vertical emissivity εn of about 0.1 or less) and has excellent heat insulating property and heat shielding property, and it can effectively prevent breakage of the glass substrate if its emissivity is maintained at the time of fire.

Accordingly, as the Low-E film to be used as a heat resistant Low-E film, a Low-E film containing a silver layer is preferably used. Since silver is easily oxidized when heated and its performance is likely to be deteriorated, a structure that withstands heat, that is a structure such that silver is less likely to be deteriorated by heat, is preferred. For example, the following structures (A) and (B) may be mentioned.

(A) A Low-E film having an oxide dielectric layer, a barrier layer, a silver layer, a barrier layer and an oxide dielectric layer in this order, directly formed on a glass substrate in this order. Each barrier layer is formed by a metal, and the thickness of each barrier layer is 2 nm or more. By the barrier layer being present between the silver layer and the oxide dielectric layer, oxidation of silver can be suppressed, and deterioration of heat reflecting performance can be suppressed. Further, when each barrier layer is formed of a metal and the thickness of each barrier layer is 2 nm or more, heat resistance will be favorable. The metal constituting the barrier layer may, for example, be zinc alloy (Zn alloy) or titanium (Ti).

In a case where a conventional Low-E film is used for a metal barrier layer, the thickness of the Zn alloy barrier layer is about 0.7 nm, and the thickness of the Ti barrier layer is about 1.5 nm.

The thicker (A) the barrier layer, the more favorable the heat resistance, however, the transmittance tends to lower. The thickness of (A) the barrier layer is determined considering the heat resistance and transmission.

(B) A Low-E film having a non-oxide dielectric layer, a barrier layer, a silver layer, a barrier layer and a non-oxide dielectric layer in this order, directly formed on a glass substrate in this order. By a structure such that a silver layer is sandwiched between non-oxide dielectric layers, oxidation of silver in high temperature environment can be suppressed, and while high heat reflecting performance is secured, high heat resistance can be secured.

The barrier layer in (B) is, in the same manner as the barrier layer in (A), formed of a Zn alloy, Ti or the like, whereby heat resistance can further be improved. The barrier layer in (B) may be formed of the same material as the non-oxide dielectric layer.

The Low-E film may contain a plurality of silver layers. By forming a plurality of silver layers, the emissivity can further be lowered, and εn can be made much lower than 0.1. For example, the Low-E film has an oxide dielectric layer, a barrier layer, a silver layer, a barrier layer, an oxide dielectric layer, a barrier layer, a silver layer, a barrier layer and an oxide dielectric layer in this order directly formed on a glass substrate in this order.

The third dielectric layer 17 protects the radio wave reflective layer 16. The third dielectric layer 17 is formed of e.g. glass, a ceramic or a resin. From the viewpoint of weight saving, a resin is preferred. As specific examples of the resin, a PET resin, a PC resin and an acrylic resin may be mentioned. Further, from the viewpoint of scratch resistance, glass or a ceramic is preferred.

In a case where the third dielectric layer 17 is a glass substrate or a ceramic substrate, its thickness is for example from 0.2 mm to 4.0 mm, preferably from 0.3 mm to 2.5 mm, more preferably from 0.3 mm to 1.0 mm. On the other hand, in a case where the third dielectric layer 17 is a resin substrate, its thickness if form example from 0.4 mm to 5.0 mm, preferably from 0.5 mm to 3.5 mm, more preferably from 0.5 mm to 1.5 mm.

In a case where the third dielectric layer 17 is a glass substrate, tanδ of the glass substrate is preferably 0.025 or less, more preferably 0.020 or less, further preferably 0.010 or less. The lower limit of tanδ of the glass substrate is not particularly limited and may be 0.0001 or more. Further, the relative dielectric constant of the glass substrate is preferably 8 or less, more preferably 6 or less. The lower limit of the relative dielectric constant of the glass substrate is not particularly limited and may be 3.5 or more.

In a case where the third dielectric layer 17 is a resin substrate, tanδ of the resin substrate is preferably 0.2 or less, more preferably 0.1 or less. The lower limit of tanδ of the resin substrate is not particularly limited and may be 0.0005 or more. Further, the relative dielectric constant of the resin substrate is preferably 5 or less, more preferably 4 or less. The lower limit of the relative dielectric constant of the resin substrate is not particularly limited and may be 2 or more.

The ratio (Te/Tc) of the thickness (Te) of the third dielectric layer 17 to the thickness (Tc) of the second dielectric layer 15 is for example from 0.05 to 0.75. The third dielectric layer 17 is intended to protect the radio wave reflective layer 16 and thereby may be thinner than the second dielectric layer 15.

The total thickness of the radio wave absorber 1 is for example from 1.0 mm to 30 mm, more preferably from 2.0 mm to 20 mm, further preferably from 2.5 mm to 15 mm, particularly preferably from 2.5 mm to 12 mm. When the thickness of the radio wave absorber 1 is within the above range, the respective first dielectric layer 13, second dielectric layer 15 and third dielectric layer 17 can be made to have appropriate thicknesses and the radio wave absorber 1 can be made light in weight.

The adhesive layer 18 bonds adjacent layers. The adhesive layer 18 is formed of, for example, any of an optical clear adhesive (OCA), a polyvinyl butyral (PVB) resin, an ethylene-vinyl acetate (EVA) resin, a cycloolefin polymer (COP) resin and a thermoplastic polyurethane (TPU) resin.

The coefficient of water absorption of the adhesive layer 18 is for example 3 mass% or less. The coefficient of water absorption of the adhesive layer 18 is measured in accordance with Japanese Industrial Standards JIS K7209: 2000. When the coefficient of water absorption of the adhesive layer 18 is 3 mass% or less, the adhesive layer 18 is less likely to be deteriorated even in an use environment at high temperature under high humidity. The PVB resin, the EVA resin, the COP resin and the TPU resin may have a coefficient of water absorption of 3 mass% or less. The coefficient of water absorption of the adhesive layer 18 is preferably 1 mass% or less. Further, the coefficient of water absorption of the adhesive layer 18 is 0.01 mass% or more.

Dispersing fine particles of a mineral having a high relative dielectric constant in the adhesive layer 18 thereby to make the relative dielectric constant of the adhesive layer 18 high, is also effective to make the thickness of the whole radio wave absorber 1 thin. In such a case, it is preferred that the difference in the relative dielectric constant between each of the first dielectric layer 13, the second dielectric layer 15 and the third dielectric layer 17, and the adhesive layer 18, is small, with a view to suppressing influence of reflection of radio waves between the respective members.

Further, for example, in a case where the difference in the relative dielectric constant between the first dielectric layer 13 and the second dielectric layer 15 is large, it is preferred that the adhesive layer 18 disposed between them has a relative dielectric constant in between the relative dielectric constants of the first dielectric layer 13 and the second dielectric layer 15. Likewise, in a case where the difference in the relative dielectric constant between the second dielectric layer 15 and the third dielectric layer 17 is large, it is preferred that the adhesive layer 18 disposed between them has a relative dielectric constant in between the relative dielectric constants of the second dielectric layer 15 and the third dielectric layer 17.

Finally, examples of the radio wave absorber 1 of which the attenuation of radio waves at a frequency of 915 MHz is -20 dB or less and the band width at which the attenuation becomes -10 db or less is 26 MHz or more, are shown in Tables 6 to 8.

[Table 6]

| Second dielectric layer | | Conductive layer | | | | Attenuation at frequency of 915 MHz [dB] | Minimum attenuation [dB] | Frequency at which attenuation becomes minimum [MHz] | Band width at which attenuation becomes -10 dB or less [MHz] |
|---|---|---|---|---|---|---|---|---|---|
| Material | Thickness [mm] | L1 [mm] | L2 [mm] | G [μm] | Sheet resistance [Ω/sq.] | | | | |
| PC | 10 | 33.0 | 18.0 | 100 | 15 | -24.1 | -25.2 | 909.6 | 123.6 |
| PC | 8 | 34.0 | 26.0 | 100 | 10 | -21.5 | -22.8 | 921.5 | 103.0 |
| PC | 6 | 42.5 | 32.1 | 110 | 5 | -20.8 | -29.5 | 924.0 | 74.1 |
| Glass | 8 | 25.6 | 16.0 | 125 | 10 | -22.0 | -22.0 | 914.4 | 99.1 |
| Glass | 6 | 26.0 | 22.0 | 108 | 5 | -24.9 | -25.0 | 914.4 | 73.8 |
| Glass | 4 | 35.0 | 21.0 | 105 | 1.8 | -27.2 | -32.0 | 917.6 | 46.9 |

In Table 6, the radio wave absorber 1 was a 5-layered laminate having the first dielectric layer 13, the conductive layer 14, the second dielectric layer 15, the radio wave reflective layer 16 and the third dielectric layer 17 in this order. The laminate was disposed so that the first principal surface 11 stood vertically, the longitudinal direction of the first slits 14c was horizontal, and the longitudinal direction of the second slits 14d was vertical. The first dielectric layer 13 and the third dielectric layer 17 were both PC resin substrates having a thickness of 2.0 mm. The radio wave reflective layer 16 was a perfect magnetic conductor.

[Table 7]

| Second dielectric layer | | Conductive layer | | | | Attenuation at frequency of 915 MHz [dB] | Minimum attenuation [dB] | Frequency at which attenuation becomes minimum [MHz] | Band width at which attenuation becomes -10 dB or less [MHz] |
|---|---|---|---|---|---|---|---|---|---|
| Material | Thickness [mm] | L1 [mm] | L2 [mm] | G [μm] | Sheet resistance [Ω/sq.] | | | | |
| PC | 3 | 40.0 | 28.0 | 100 | 1.8 | -29.2 | -34.3 | 917.6 | 46.6 |
| PC | 6 | 28.0 | 17.0 | 105 | 7.0 | -29.8 | -32.1 | 917.6 | 86.2 |

In Table 7, the radio wave absorber 1 was a 8-layered laminate having the first dielectric layer 13, the conductive layer 14, the adhesive layer 18, the second dielectric layer 15, the adhesive layer 18, the radio wave reflective layer 16, the adhesive layer 18 and the third dielectric layer 17 in this order. The laminate was disposed so that the first principal surface 11 stood vertically, the longitudinal direction of the first slits 14c was horizontal, and the longitudinal direction of the second slits 14d was vertical. The first dielectric layer 13 and the third dielectric layer 17 were both glass substrates having a thickness of 2.75 mm. The radio wave reflective layer 16 was a perfect magnetic conductor. Each adhesive layer 18 was a COP film having a thickness of 0.5 mm.

[Table 8]

| Second dielectric layer | | Conductive layer | | | | Attenuation at frequency of 915 MHz [dB] | Minimum attenuation [dB] | Frequency at which attenuation becomes minimum [MHz] | Band width at which attenuation becomes -10 dB or less [MHz] |
|---|---|---|---|---|---|---|---|---|---|
| Material | Thickness [mm] | L1 [mm] | L2 [mm] | G [μm] | Sheet resistance [Ω/sq.] | | | | |
| Glass | 3.7 | 34.0 | 24.0 | 110 | 1.8 | -24.5 | -24.5 | 915.0 | >45.5 |

In Table 8, the radio wave absorber 1 was a 8-layered laminate having the first dielectric layer 13, the adhesive layer 18, the conductive layer 14, the second dielectric layer 15, the adhesive layer 18, the radio wave reflective layer 16, the adhesive layer 18 and the third dielectric layer 17 in this order. The laminate was disposed so that the first principal surface 11 stood vertically, the longitudinal direction of the first slits 14c was horizontal, and the longitudinal direction of the second slits 14d was vertical. The first dielectric layer 13 was a glass substrate having a thickness of 2.75 mm, and the third dielectric layer 17 was a PC resin substrate having a thickness of 2.75 mm. The radio wave reflective layer 16 is a perfect magnetic conductor. Each adhesive layer 18 was a COP film having a thickness of 0.5 mm.

EXAMPLES

Now, experimental data will be described below. Ex. 1 and 2 are both Examples of the present invention.

[Ex. 1]

In Ex. 1, a 8-layered radio wave absorber having a first dielectric layer, an adhesive layer, a conductive layer, a second dielectric layer, an adhesive layer, a radio wave reflective layer, an adhesive layer and a third dielectric layer in this order, shown in Table 9, was prepared.

The first dielectric layer and the third dielectric layer were soda lime glass having a thickness of 2.75 mm.

[Table 9]

| | Material | Thickness [mm] | Relative dielectric constant | tanδ | Sheet resistance [Ω/sq.] |
|---|---|---|---|---|---|
| First dielectric layer | Soda lime glass | 2.75 | 7.00 | 0.02 | |
| Adhesive layer | COP film | 1.00 | 2.33 | 0.00086 | |
| Conductive layer | Conductive film containing silver oxide | - | | | 1.8 |
| Second dielectric layer | Soda lime glass | 3.70 | 7.00 | 0.02 | |
| Adhesive layer | COP film | 1.00 | 2.33 | 0.00086 | |
| Radio wave reflective layer | Stainless steel mesh | - | | | 0.01 |
| Adhesive layer | COP film | 1.00 | 2.33 | 0.00086 | |
| Third dielectric layer | Soda lime glass | 2.75 | 7.00 | 0.02 | |

The first dielectric layer and the third dielectric layer were soda lime glass having a thickness of 2.75 mm. The second dielectric layer was soda lime glass having a thickness of 3.7 mm. The conductive layer was directly formed on one side of the second dielectric layer. The conductive layer was a laminated film containing silver oxide having a surface resistance of 1.8 Ω/sq. Further, for patterning of the conductive layer, laser processing was employed. Of the conductive layer, L1 was 34 mm, L2 was 24 mm, and G1 and G2 were 110 μm. As the radio wave reflective layer, a metal mesh (surface resistance: 0.01 Ω/sq.) woven with stainless steel fibers having a line width of 30 μm was used. As the adhesive layer, a COP film having a relative dielectric constant of 2.33 and a thickness of 1000 μm was used. Bonding using the COP film was conducted at a temperature of 130°C with a pressure applied of 1 MPa for a pressurizing time of 90 minutes. The radio wave absorber had a rectangular first principal surface of 400 mm in width and 900 mm in length, had a total thickness of 12.2 mm and a transmittance of 62%.

The attenuation of radio waves by the radio wave absorber prepared in Ex. 1 was measured as follows. As shown in Fig. 8, radio waves were made to enter the first principal surface 11 of the radio wave absorber 1 from a transmitting antenna 21 at an angle of incidence $\theta_i$ of 30°. The radio waves reflected at an angle of incidence $\theta_i$ of 30° were received by a receiving antenna 22. The transmitting antenna 21 and the receiving antenna 22 were disposed symmetrical to the normal to the first principal surface 11 of the radio wave absorber 1 at a position 1000 nm apart from the first principal surface 11. The radio wave absorber 1 was disposed so that the first principal surface 11 stood vertically. The attenuation was obtained as the attenuation of the intensity of received radio waves to the intensity of transmitted radio waves. The frequency of radio waves was from 800 MHz to 1000 MHz. Measurement of the attenuation was conducted in an electromagnetic anechoic chamber, so as to reduce influence of unnecessary radio waves emitted from ones other than the transmitting antenna 21.

The results of measurement of the attenuation of radio waves by the radio wave absorber prepared in Ex. 1 are shown in Fig. 9. In Fig. 9, for comparison, results of measurement of the attenuation of radio waves by a stainless steel plate (SUS plate) which is a perfect magnetic conductor are also shown. In Fig. 9, the attenuation by the SUS plate is negative values due to influence of diffraction and leakage of radio waves. The ratio of the attenuation of radio waves by the radio wave absorber prepared in Ex. 1 to the attenuation of radio waves by a SUS plate is shown in Fig. 10. As evident from Figs. 9 and 10, it was confirmed that the radio wave absorber prepared in Ex. 1 had large absorption at a frequency in the vicinity of 880 MHz. Further, the distance between the conductive layer and the radio wave reflective layer can be made smaller than λ/4, such being preferred in view of weight saving.

[Ex. 2]

In Ex. 2, a 8-layered radio wave absorber having a first dielectric layer, a conductive layer, an adhesive layer, a second dielectric layer, an adhesive layer, a radio wave reflective layer, an adhesive layer and a third dielectric layer in this order, shown in Table 10, was prepared.

[Table 10]

| | Material | Thickness [mm] | Relative dielectric constant | tanδ | Sheet resistance [Ω/sq.] |
|---|---|---|---|---|---|
| First dielectric layer | Soda lime glass | 2.75 | 7.00 | 0.02 | |
| Conductive layer | Conductive film containing silver oxide | - | | | 1.8 |
| Adhesive layer | COP film | 0.38 | 2.33 | 0.00086 | |
| Second dielectric layer | PC substrate | 3.00 | 2.96 | 0.011 | |
| Adhesive layer | COP film | 0.38 | 2.33 | 0.00086 | |
| Radio wave reflective layer | Stainless steel mesh | - | | | 0.01 |
| Adhesive layer | COP film | 0.38 | 2.33 | 0.00086 | |
| Third dielectric layer | Soda lime glass | 2.75 | 7.00 | 0.02 | |

The first dielectric layer and the third dielectric layer were soda lime glass having a thickness of 2.75 mm. The second dielectric layer was a PC (polycarbonate) substrate having a thickness of 3.0 mm. The conductive layer was directly formed on one surface of the first dielectric layer. The conductive layer was a laminated film containing silver oxide having a surface resistance of 1.8 Ω/sq. For patterning of the conductive layer, laser processing was employed. Of the conductive layer, L1 was 40 mm, L2 was 28 mm, and G1 and G2 were 100 μm. As the radio wave reflective layer, a metal mesh (surface resistance: 0.01 Ω/sq.) woven with stainless steel fibers having a line width of 30 μm was used. As the adhesive layer, a COP film having a relative dielectric constant of 2.33 and a thickness of 380 μm was used. Bonding using the COP film was conducted at a temperature of 130°C with a pressure applied of 1 MPa for a pressurizing time of 90 minutes. The radio wave absorber had a 300 mm square first principal surface and had a total thickness of 9.7 mm and a transmittance of 64%.

The attenuation of radio waves by the radio wave absorber prepared in Ex. 2 was measured in the same manner as the attenuation of radio waves by the radio wave absorber prepared in Ex. 1. The measurement results are shown in Fig. 11. In Fig. 11, for comparison, results of measurement of the attenuation of radio waves by a SUS plate which is a perfect magnetic conductor are also shown. In Fig. 11, the attenuation by the SUS plate is negative values due to influence of diffraction and leakage of radio waves. The ratio of the attenuation of radio waves by the radio wave absorber prepared in Ex. 2 to the attenuation of radio waves by a SUS plate is shown in Fig. 12. As evident from Figs. 11 and 12, it was confirmed that the radio wave absorber prepared in Ex. 2 had large absorption at a frequency in the vicinity of 924 MHz. Further, the distance between the conductive layer and the radio wave reflective layer can be made smaller than λ/4, such being preferred in view of weight saving.

The radio wave absorber according to the present disclosure has been described above. However, it should be understood that the present invention is by no means restricted to the above specific embodiments. Various changes, modification, replacement, addition, deletion and combination are possible within the scope of Claims. They of course belong to the technical range of the present disclosure.

For example, the frequency of radio waves absorbed by the radio wave absorber 1 is not limited to 913 MHz for RFID (Radio Frequency IDentification). The frequency of radio waves absorbed by the radio wave absorber 1 may, for example, be from 0.5 GHz to 2 GHz, preferably from 0.8 GHz to 1.2 GHz. For example, the frequency of radio waves from a mobile phone is 1 GHz.

REFERENCE SYMBOLS

1: radio wave absorber
11: first principal surface
12: second principal surface
13: first dielectric layer
14: conductive layer
14a: conductor
15: second dielectric layer
16: radio wave reflective layer
17: third dielectric layer

The entire disclosure of Japanese Patent Application No. 2020-140958 filed on August 24, 2020 including specification, claims, drawings and summary is incorporated herein by reference in its entirety.

## Claims

1. A radio wave absorber having a layered structure,

    which has a visible light transmittance of 50% or more,
    which absorbs radio waves in a specific frequency band,
    which has a first principal surface to which the radio waves enter and a second principal surface on the opposite side from the first principal surface,
    which has a first dielectric layer, a conductive layer, a second dielectric layer, a radio wave reflective layer and a third dielectric layer in this order from the first principal surface toward the second principal surface, and
    wherein the conductive layer comprises a plurality of conductors and gaps disposed to separate the plurality of conductors, and the plurality of conductors are insulated from each other.

2. The radio wave absorber according to Claim 1, which further has an adhesive layer between the first principal surface and the second principal surface.

3. The radio wave absorber according to Claim 2, wherein the adhesive layer is formed of any of an optical clear adhesive (OCA), a polyvinyl butyral (PVB) resin, an ethylene-vinyl acetate (EVA) resin, a cycloolefin polymer (COP) resin and a thermoplastic polyurethane (TPU) resin.

4. The radio wave absorber according to Claim 2 or 3, wherein the adhesive layer has a coefficient of water absorption of 3 mass% or less.

5. The radio wave absorber according to any one of Claims 1 to 4, wherein the conductive layer is adjacent to one of the first dielectric layer and the second dielectric layer, and is directly formed on the one of the first dielectric layer and the second dielectric layer.

6. The radio wave absorber according to any one of Claims 1 to 5, wherein the radio wave reflective layer is adjacent to one of the second dielectric layer and the third dielectric layer, and is directly formed on the one of the second dielectric layer and the third dielectric layer.

7. The radio wave absorber according to any one of Claims 1 to 6, wherein the radio wave reflective layer has conductivity.

**8.** The radio wave absorber according to Claim 7, wherein the radio wave reflective layer contains a transparent conductive film.

**9.** The radio wave absorber according to Claim 7, wherein the radio wave reflective layer contains a metal mesh.

**10.** The radio wave absorber according to any one of Claims 7 to 9, wherein the radio wave reflective layer has a sheet resistance lower than 3 Ω/sq.

**11.** The radio wave absorber according to any one of Claims 1 to 10, wherein the second dielectric layer is formed of a polycarbonate (PC) resin or an acrylic resin.

**12.** The radio wave absorber according to any one of Claims 1 to 11, wherein at least one of the first dielectric layer and the third dielectric layer is formed of glass.

**13.** The radio wave absorber according to any one of Claims 1 to 12, wherein in the conductive layer, the line width of the gaps to separate the plurality of conductors is from 30 μm to 500 μm.

**14.** The radio wave absorber according to any one of Claims 1 to 13, wherein the conductive layer has, as the gaps to separate the plurality of conductors, a plurality of first slits and a plurality of second slits orthogonal to each other,

the longitudinal direction of the first slit is horizontal and the longitudinal direction of the second slit is vertical, and the ratio of the absolute value of the difference between the average of the line widths of the first slits and the average of the line widths of the second slits, to the average of the line widths of the first slits, is 30% or less.

**15.** The radio wave absorber according to any one of Claims 1 to 14, wherein the ratio (Ta/Tc) of the thickness (Ta) of the first dielectric layer to the thickness (Tc) of the second dielectric layer is from 0.05 to 0.75.

**16.** The radio wave absorber according to any one of Claims 1 to 15, wherein the frequency of the radio waves is from 0.5 GHz to 2 GHz.

**17.** The radio wave absorber according to any one of Claims 1 to 16, wherein the thickness of the second dielectric layer is from 1.5 mm to 20 mm.

**18.** The radio wave absorber according to any one of Claims 1 to 17, wherein the following formula (1) is satisfied:

$$0.23x^2 - 1.50x + 2.41 \leqq y \leqq 0.11x^2 + 1.09x - 1.36 \qquad (1)$$

wherein x (mm) is the thickness of the second dielectric layer, and y (Ω/sq.) is the sheet resistance of the conductors in the conductive layer.

**19.** The radio wave absorber according to any one of Claims 1 to 18, wherein the conductive layer further has an insulating substrate which supports the plurality of conductors.

Fig. 1

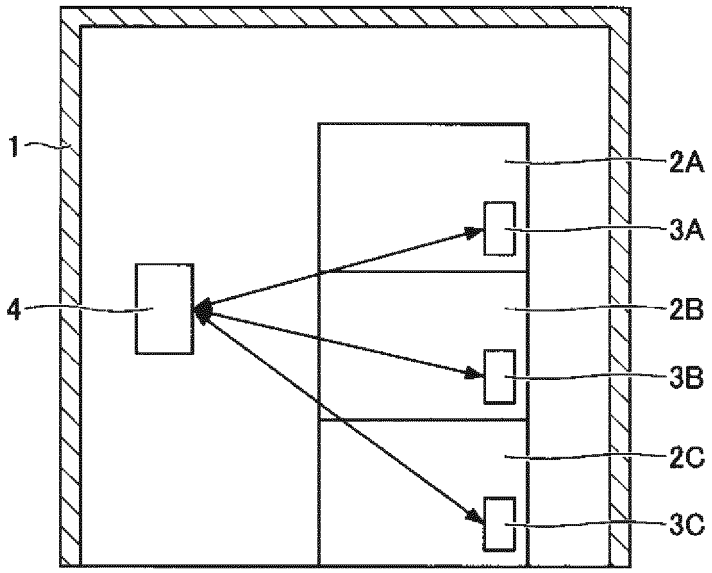


Fig. 2

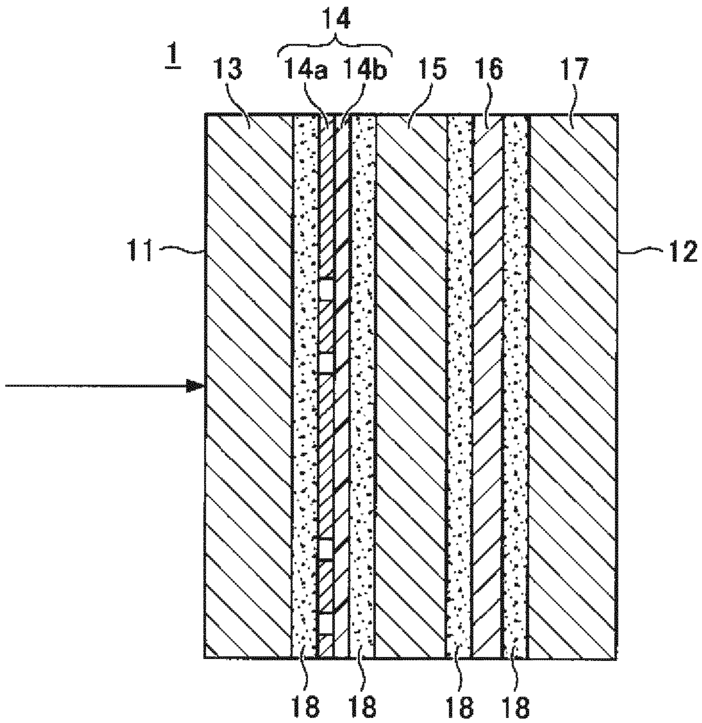

Fig. 3

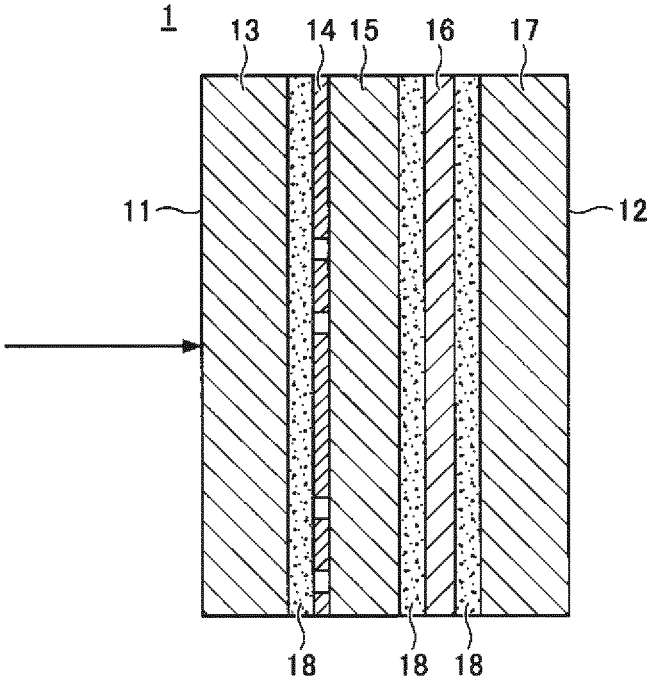


Fig. 4

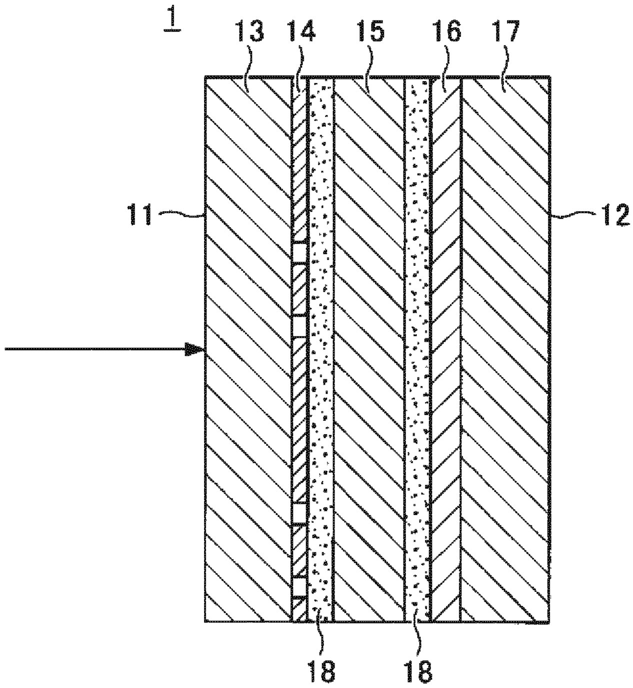

Fig. 5

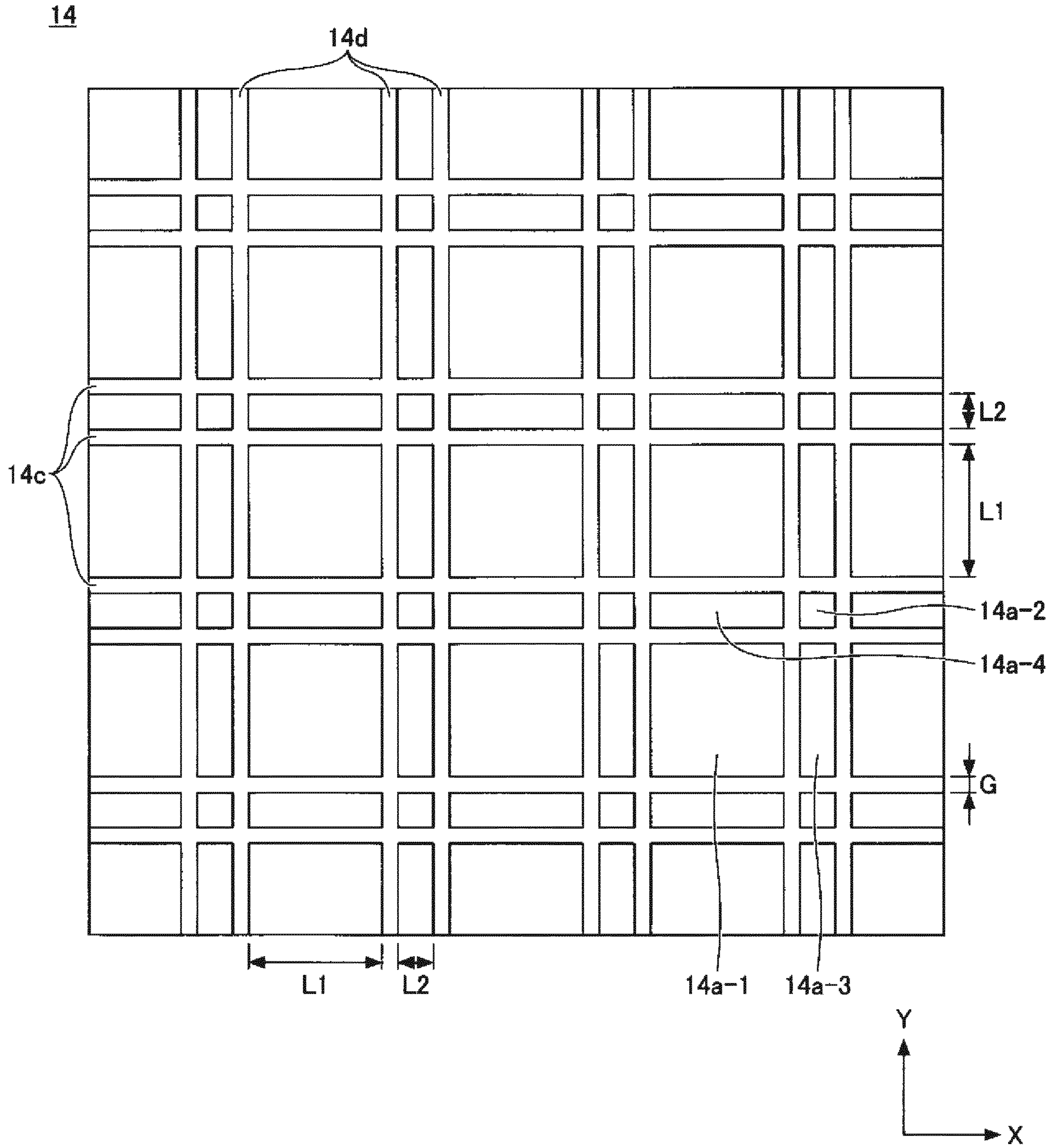

Fig. 6

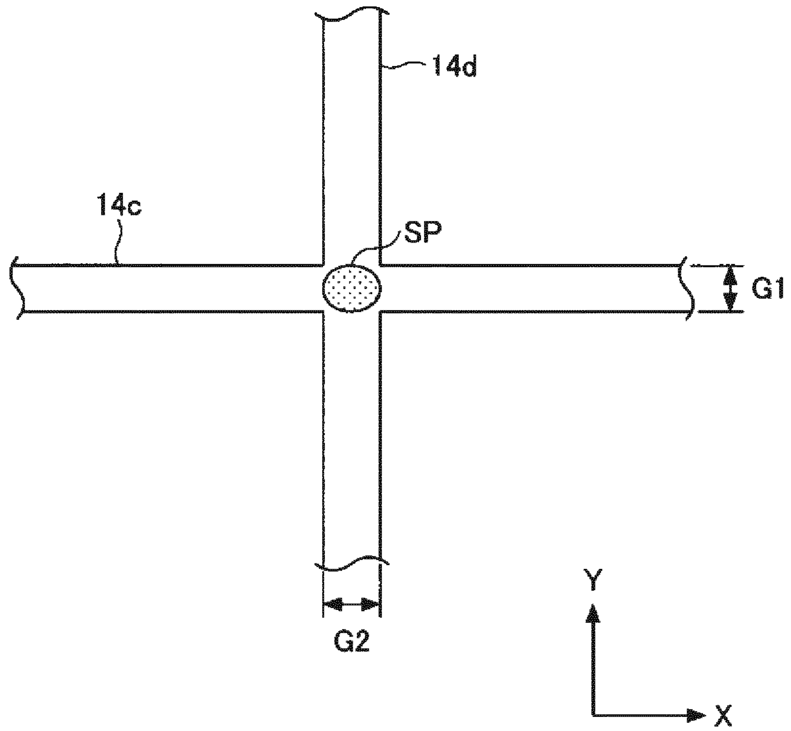

Fig. 7

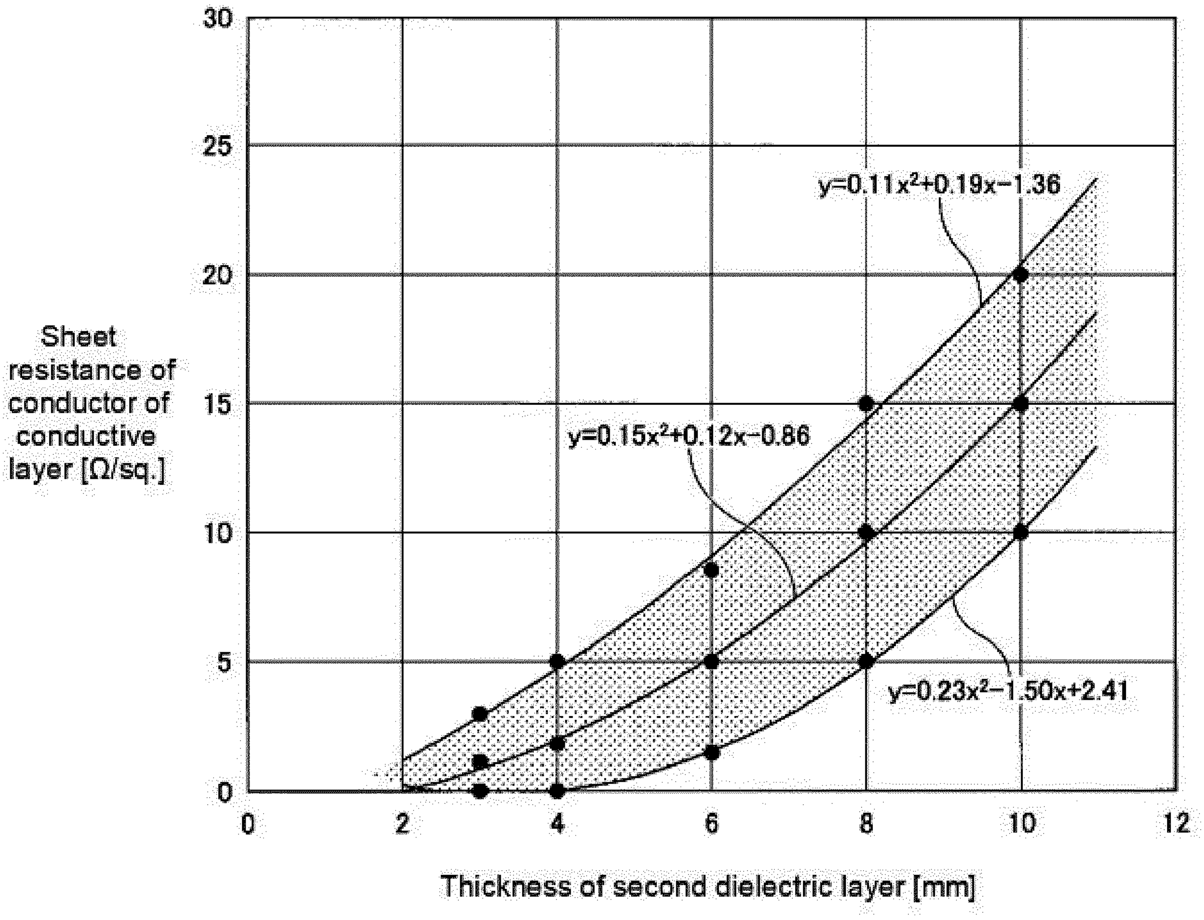
30
25
20
15
10
5
0
0
2
4
6
8
10
12
Sheet resistance of conductor of conductive layer [Ω/sq.]
Thickness of second dielectric layer [mm]
y=0.11x²+0.19x−1.36
y=0.15x²+0.12x−0.86
y=0.23x²−1.50x+2.41

Fig. 8

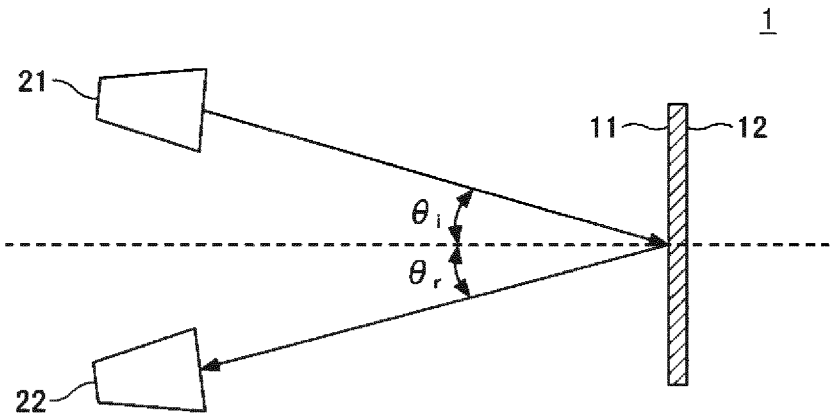
1
21
22
11
12
θi
θr

Fig. 9

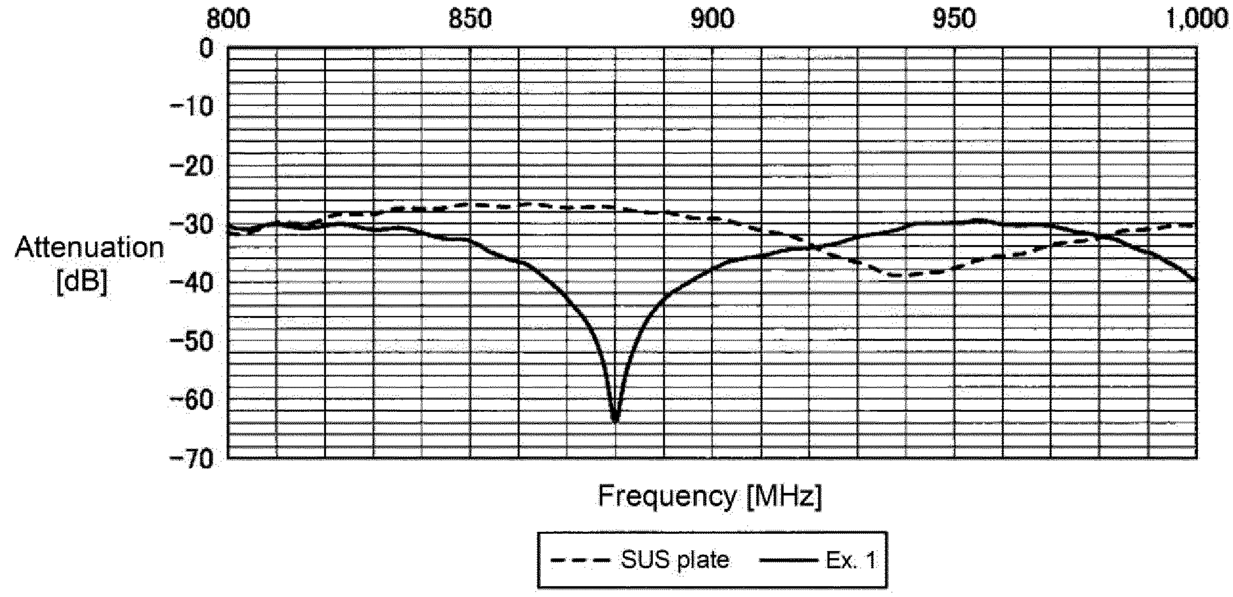
800
850
900
950
1,000
0
-10
-20
-30
-40
-50
-60
-70
Attenuation [dB]
Frequency [MHz]
SUS plate
Ex. 1

Fig. 10

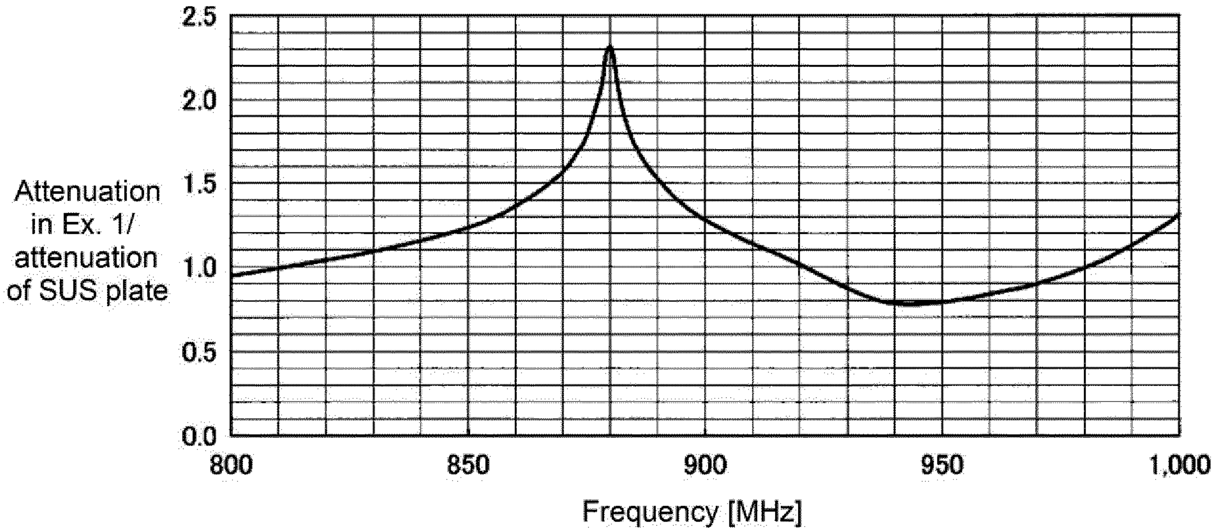
2.5
2.0
1.5
1.0
0.5
0.0
Attenuation in Ex. 1/ attenuation of SUS plate
800
850
900
950
1,000
Frequency [MHz]

Fig. 11

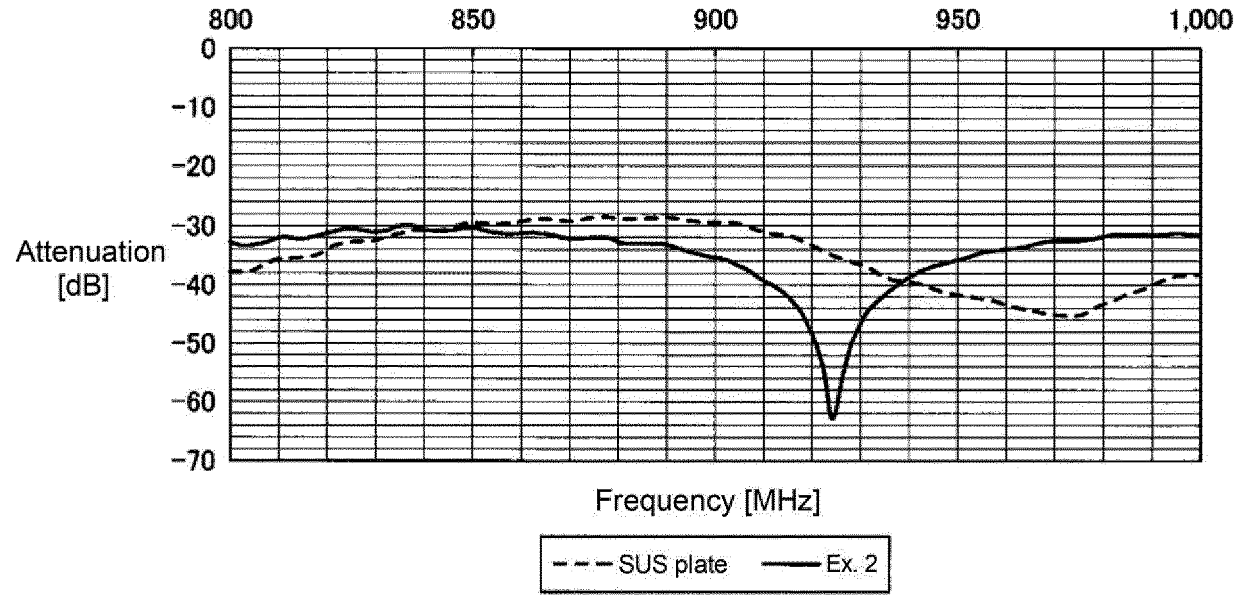
800
850
900
950
1,000
0
-10
-20
-30
-40
-50
-60
-70
Attenuation [dB]
Frequency [MHz]
SUS plate
Ex. 2

Fig. 12

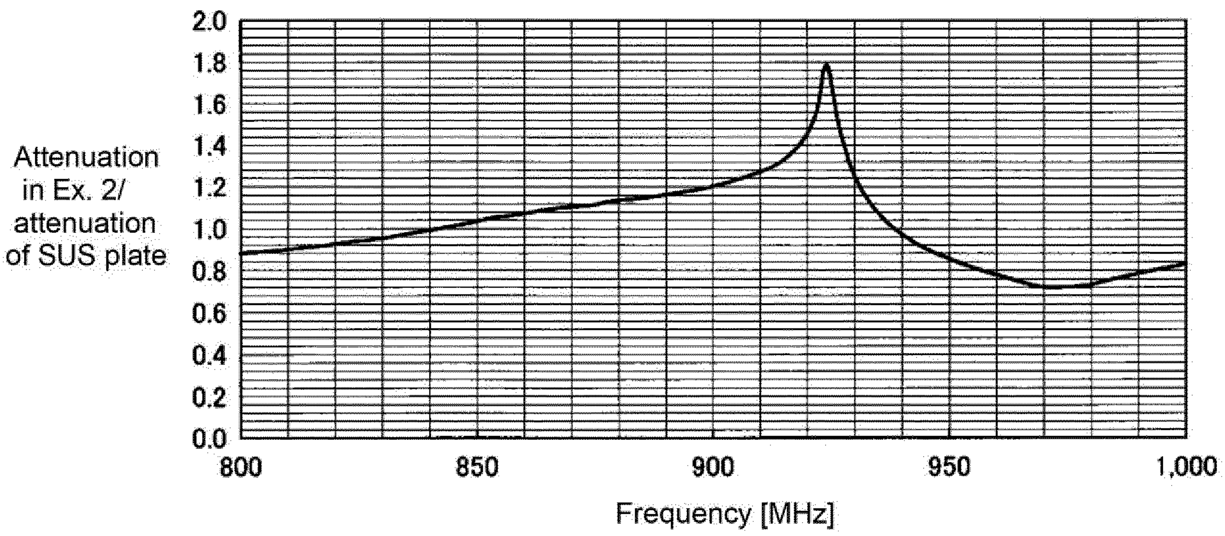
2.0
1.8
1.6
1.4
1.2
1.0
0.8
0.6
0.4
0.2
0.0
Attenuation in Ex. 2/ attenuation of SUS plate
800
850
900
950
1,000
Frequency [MHz]

**INTERNATIONAL SEARCH REPORT**

International application No.
**PCT/JP2021/030388**

**A. CLASSIFICATION OF SUBJECT MATTER**

***E04B 1/92***(2006.01)i; ***H01Q 17/00***(2006.01)i; ***H05K 9/00***(2006.01)i; ***B32B 7/025***(2019.01)i
FI: H05K9/00 V; H01Q17/00; E04B1/92; B32B7/025; H05K9/00 M

According to International Patent Classification (IPC) or to both national classification and IPC

**B. FIELDS SEARCHED**

Minimum documentation searched (classification system followed by classification symbols)

E04B1/92; H01Q17/00; H05K9/00; B32B7/025

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2004-281632 A (MITSUI CHEMICALS, INC.) 07 October 2004 (2004-10-07) paragraphs [0003]-[0011], [0035]-[0041], [0048], [0049], fig. 1, 2, 8 | 1-19 |
| Y | JP 2010-3964 A (FUJIMORI KOGYO CO., LTD.) 07 January 2010 (2010-01-07) paragraphs [0016], [0063]-[0067], fig. 5 | 1-19 |
| Y | JP 2011-91090 A (HITACHI CHEMICAL CO., LTD.) 06 May 2011 (2011-05-06) paragraphs [0008], [0011] | 3, 4 |
| A | WO 2012/133419 A1 (NITTO DENKO CORP.) 04 October 2012 (2012-10-04) entire text, all drawings | 1-19 |
| A | JP 2010-10612 A (ASAHI GLASS CO., LTD.) 14 January 2010 (2010-01-14) entire text, all drawings | 1-19 |
| A | JP 2009-76802 A (MITSUBISHI CABLE INDUSTRIES, LTD.) 09 April 2009 (2009-04-09) entire text, all drawings | 1-19 |
| A | JP 2011-204732 A (MITSUBISHI PAPER MILLS LIMITED) 13 October 2011 (2011-10-13) entire text, all drawings | 1-19 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 October 2021** | **09 November 2021** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2021/030388**

| Patent document cited in search report | Publication date (day/month/year) | Patent family member(s) | Publication date (day/month/year) |
|---|---|---|---|
| JP 2004-281632 A | 07 October 2004 | (Family: none) | |
| JP 2010-3964 A | 07 January 2010 | (Family: none) | |
| JP 2011-91090 A | 06 May 2011 | (Family: none) | |
| WO 2012/133419 A1 | 04 October 2012 | JP 2012-209515 A<br>entire text, all drawings | |
| JP 2010-10612 A | 14 January 2010 | (Family: none) | |
| JP 2009-76802 A | 09 April 2009 | (Family: none) | |
| JP 2011-204732 A | 13 October 2011 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006086446 A
- JP 2020140958 A